# EUROPÄISCHE PATENTSCHRIFT

(11) **EP 0 260 221 B1**
(45) Veröffentlichungstag und Bekanntmachung des Hinweises auf die Patenterteilung: **30.06.1993**
(21) Anmeldenummer: 87730100.2
(22) Anmeldetag: 03.09.1987
(51) Int. Cl.: G06K 7/08, H04B 5/00, G07C 9/00

(54) **Verfahren zur kontaktlosen Informationsübertragung**
Method for contactless information transmission
Méthode pour la transmission d'information sans contact

(30) Priorität: 06.09.1986 DE 3630456
(43) Veröffentlichungstag der Anmeldung: 16.03.1988
(73) Patentinhaber: IKON AKTIENGESELLSCHAFT Präzisionstechnik, D-14167 Berlin (DE)
(72) Erfinder: Ballmer, Horst, D-7920 Heidenheim (DE); Grosskopf, Rudolf, Dr., D-7923 Königsbronn (DE)

(56) Entgegenhaltungen:
- DE-A- 2 812 388
- DE-A- 3 149 789
- DE-A- 3 611 441
- GB-A- 2 149 548
- US-A- 3 716 701

## Beschreibung

Die Erfindung betrifft ein Verfahren zur kontaktlosen Informationsübertragung zwischen einem Datenträger und einem Datenleser, wobei Datengeber und Datenleser ortsunabhängig zueinander sind und zur Informationsübertragung zusammengebracht werden.

Aus der GB-A 2 149 548 ist ein Verfahren zur kontaktlosen Informationsubertragung zwischen einem Datenträger und einem Datenleser und -geber bekannt. Beide sind unabhängig voneinander und werden zur Informationsübertragung zusammengebracht, wobei eine kapazitive Kopplung erfolgt für mindestens zwei Leitungswege. Der Datenträger weist dabei drei Elektroden auf, von denen zwei über eine Gleichrichteranordnung für die Energieübertragung benutzt werden, und die dritte Elektrode mit dem Datenausgang der elektronischen Speichereinheit verbunden ist.

Eine ähnliche Vorrichtung ist aus der DE-A 28 12 388 bekannt.

Aus der DE-PS 31 49 789 ist eine Vorrichtung bekannt, die dort als induktive Identifizierung einer Information bezeichnet ist und insbesondere für das Zusammenwirken eines elektronischen Schlüssels mit einem Schloß geeignet ist. Bei dieser Vorrichtung schwingt in dem Schloß ein Oszillator und die hochfrequente Schwingung wird bei Annäherung des Schlüssels von diesem aufgenommen und mit einem als Schlüsselkennung dienenden Frequenz- oder Impulsmuster moduliert, auf das Schloß zurückübertragen und von einer elektronischen Erkennungseinrichtung im Schloß weiter verarbeitet. Die Hin- und Rückübertragung der hochfrequenten Schwingung erfolgt dabei über Spulen, also auf induktivem Weg.

Eine derartige induktive Übertragung ist bei einem Schloß-Schlüsselsystem möglich, weil auch im Schlüssel ausreichend Platz für eine Spule ist. Ein Nachteil ist jedoch das verhältnismäßig große Streufeld der Spulen, wodurch die Übertragung sehr verlustreich ist. Außerdem ist bei vielen anderen Datenträgern, wenn diese flach sind, wie z.B. bei Scheckkarten, die Unterbringung einer Spule entweder nicht möglich oder mit einer zu großen Dicke des Datenträgers verbunden.

Der vorliegenden Erfindung liegt daher die Aufgabe zugrunde, eine Vorrichtung zur kontaktlosen Informationsübertragung zu schaffen, die geringe Übertragungsverluste hat und auch für flache Datenträger geeignet ist. Die Erfindung soll außerdem eine Energieübertragung und die Veränderung des elektronischen Speichers vom Datenträger ermöglichen.

Die gestellte Aufgabe wird erfindungsgemäß mit den Merkmalen des Anspruchs 1 gelöst.

Die erfindungsgemäße Lösung ist nicht auf die Übertragung von Informationen von einem Datenträger zu einem Datenleser beschränkt. Vielmehr kann der Datenleser auch gleichzeitig als Datengeber ausgebildet sein und der Datenträger kann dementsprechend zur Aufnahme von bzw. Veränderung seiner Informationen ausgebildet sein.

Weitere vorteilhafte Ausgestaltungen der Erfindung gehen aus den Unteransprüchen hervor.

Die Erfindung wird im folgenden anhand von in den Figuren dargestellten Ausführungsbeispielen näher erläutert. Dabei zeigen
- Fig. 1: eine Ausführungsform, bei welcher der Inhalt des Datenträgers verändert werden kann,
- Fig. 2: den Aufbau einer Speichereinheit,
- Fig. 3: einen Programmschutz für eine Speichereinheit und
- Fig. 4: ein Anwendungsbeispiel für die Kennzeichnung von Teilen an ihrer Oberfläche.

Der Datenträger hat Kartenform, wie sie z.B. bei Scheckkarten verwendet wird.

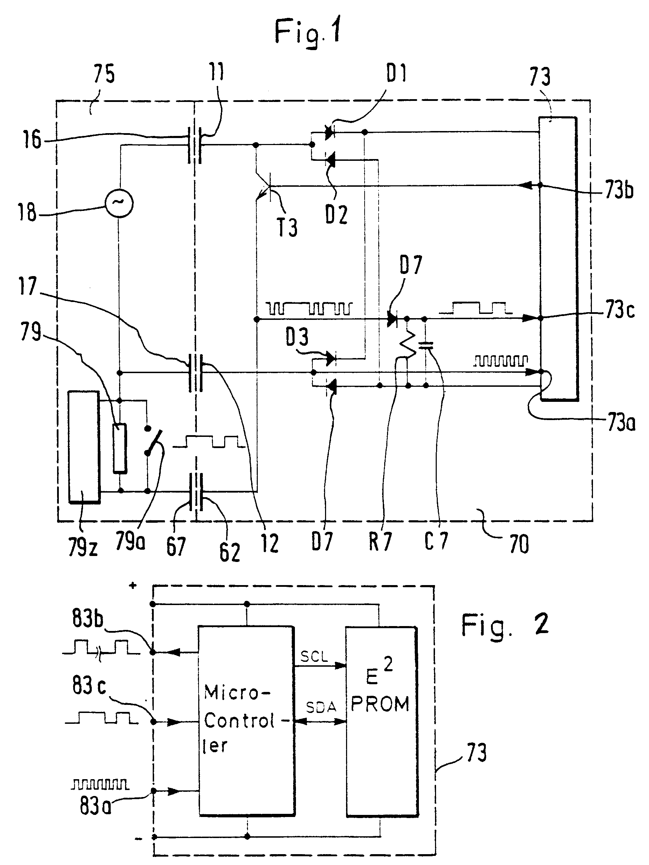

In Figur 1 ist eine besonders vorteilhafte Ausführungsform der Erfindung dargestellt, bei welcher der Inhalt des Datenträgers (70) verändert werden kann. Dazu wird der Widerstand (79) nicht nur zur Abnahme des Spannungsabfalles an ihm für den Lesevorgang benutzt, sondern der Widerstand (79) wird selbst, z.B. mit einem Schalter (79a), moduliert und diese Modulation wird im Datenträger (70) am Emitter des Transistors (T3) abgenommen. Dabei wird zweckmäßigerweise die Datenübertragung zum Datenträger (70) und zum Datenleser und -geber (75) zeitlich voneinander getrennt.

Der Generator (18) erzeugt ein Taktsignal, welches über die Elektrode (12) der Speichereinheit (73) am Takteingang (73a) zugeführt wird. Dieses Taktsignal wird durch den Schalter (79a) derart moduliert, daß immer mehrere Taktimpulse eine höhere oder niedrigere Spannung erhalten, welche dem Datenträger (70) über die Elektrode (62) zugeführt werden. Durch die Diode (D7) und den Tiefpaß aus dem Widerstand (R7) und dem Kondensator (C7) wird das hochfrequente modulierte Taktsignal demoduliert und anschließend dem Schreibeingang (73c) der Speichereinheit (73) zugeführt. Auch in diesem Fall ist die Speichereinheit in bekannter Technik ausgeführt und kann z.B. mit den meisten Ein-Chip-Mikroprozessoren realisiert werden, wobei als Datenspeicher ein elektrisch programmier- und löschbarer Speicher verwendet wird.

In Figur 2 ist ein Ausführungsbeispiel für die Speichereinheit (73) dargestellt. Bei diesem wird ein Mikroprozessor bzw. -controller Valvo PCB 84COO und ein elektrisch programmierbarer Speicher (E²PROM) Valvo PCB 8582 verwendet. Mit (+) und (-) ist die Spannungsversorgung für beide Bauteile gekennzeichnet. Dem Eingang (83a) wird das Taktsignal für den Mikrocontroller zugeführt. Von den 8 Leitungen des Porteinganges (83c) wird nur eine beliebige Leitung als Schreibeingang benutzt. Ebenso wird von den 8 Leitungen des Portausganges (83b) nur eine beliebige Leitung benutzt. Zwischen dem Mikrocontroller und dem E²PROM besteht eine Verbindung (SCL) für das serielle Taktsignal des Mikrocontrollers und eine bidirektionale Verbindung (SDA) für die serielle Datenübertragung zum und vom E²PROM.

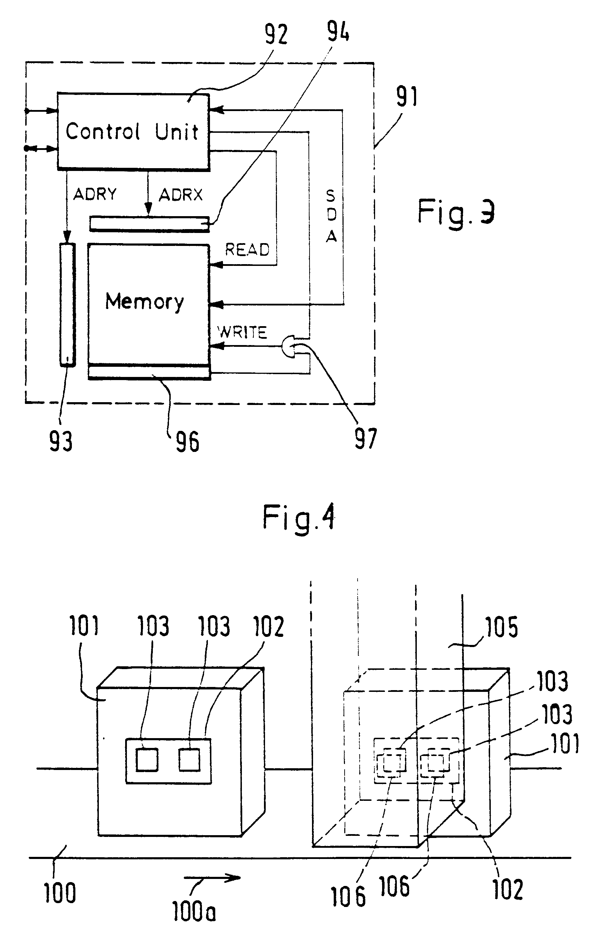

In einer vorteilhaften Ausführungsform, wird das E²PROM durch ein kundenspezifisches Bauteil ersetzt, welches in Figur 3 dargestellt ist. Mit ihm kann durch eine spezielle Schreibinformation bzw. einen letzten Programmschritt eine weitere Programmierung verhindert werden. Das kundenspezifische Bauteil (91) hat wie jeder elektrisch programmierbare Speicher eine Kontrolleinheit (92), welche mit der Speichermatrix (95) über folgende Leitungen verbunden ist: Eine bidirektionale serielle Datenleitung (SDA), die Adreßleitungen (ADRY) und (ADRX) zu dem Zeilenregister (93) und dem Spaltenregister (94), eine Leitung (READ) fur das Lesesignal und eine Leitung (WRITE) für das Schreibsignal. Die letztgenannte Leitung ist für den Schreibschutz z.B. über ein UND-Gatter (97) mit der letzten Zeile (96) der Speichermatrix (95) verknüpft. Sobald diese Zeile mit einer entsprechenden Information beschrieben ist, liegt der ihr zugehörige Eingang des UND-Gatters (97) immer auf "0", so daß fur die gesamte Speichermatrix (95) kein Schreibvorgang mehr möglich ist.

Ein derartiger Programmierschutz kann auch für bestimmte Bereiche der Speichermatrix ausgelegt werden, so daß gleichzeitig geschützte und ungeschützte Bereiche möglich sind.

Die dargestellten Ausführungsbeispiele für den Datenträger eignen sich - wie bereits erwähnt - für Scheckkarten, aber auch für jede andere Art von flachen Datenträgern, wie z.B. Ausweiskarten, Karten für Zutritts- oder Benutzungskontrolle, Karten zum Öffnen von Türen usw. Das mit Figur 1 beschriebene Ausfuhrungsbeispiel eignet sich besonders für solche Datenträger, bei denen ein veränderlicher Wert, z.B. ein Kontostand, jeweils aktualisiert werden soll.

Ein weiteres Beispiel fur die Anwendung ist in Figur 2 dargestellt. Bei diesem werden auf einem Fließband (100) in Richtung (100a) bewegte Werkstücke (101) identifiziert und/oder mit zusätzlichen Daten versehen. Hierfür ist auf jedes Werkstück (101) ein Datenträger (102) aufgeklebt, auf dem zwei oder mehr Elektroden (103) auf der gleichen Seite angeordnet sind. Ein Datenleser bzw. Datenleser und-geber (105) wird, z.B. durch (nicht gezeichnete) Berührungssensoren so an das Werkstück (101) gebracht, daß seine Elektroden (106) den Elektroden (103) des Datenträgers (102) auf dem Werkstück in geringem Abstand gegenüberstehen und der Lese- bzw. der Lese- und Schreibvorgang erfolgen kann.

## Patentansprüche

1. Verfahren zur kontaktlosen Informationsübertragung zwischen einem Datenträger (70) und einem Datenleser (75), wobei Datenträger und Datenleser ortsunabhängig zueinander sind und zur Informationsübertragung zusammengebracht werden, dadurch gekennzeichnet, daß der Datenträger (70) an seiner Oberfläche mit drei flächenartigen Elektroden (11, 12, 62) ausgebildet ist und daß der Datenleser (75) mit drei flächenartigen Elektroden (16, 17, 67) ausgebildet ist, welche zur Informationsübertragung derart mit den Elektroden (11, 12, 62) des Datenträgers (10) zusammengebracht werden, daß sie Kondensatoren (C1, C2) bilden, durch welche mindestens ein gemeinsamer Stromkreis für Datenträger und Datenleser hergestellt ist und wobei zwei Elektroden (11, 12) des Datenträgers (70) über einer Gleichrichteranordnung (D1, D2, D3, D4) und einen Transistor (T3) mit einer elektronischen Schreib-Lese-Speichereinheit (73) verbunden sind und die dritte Elektrode einerseits direkt über einen Demodulator (D7, R7, C7) mit dem Schreibeingang (73c) und andererseits über den Transistor (T3) direkt mit dem Datenausgang (73b) einer Schreib-Lese-Speichereinheit (73) verbunden ist, wobei im Datenleser und -geber (75) ein Oszillator (18) vorhanden ist, der mit zwei Elektroden (16, 17) direkt und mit der dritten Elektrode (67) über einen Widerstand (79) verbunden ist und dessen Taktsignal die Informationsübertragung zur und von der Schreib-Lese-Speichereinheit (73) steuert, und wobei der Widerstand (79) einerseits zur Informationsübertragung an die Schreib-Lese-Speichereinheit (73) durch eine Einrichtung (79a) modulierbar ist und andererseits zur Auswertung der von der Schreib-Lese-Speichereinheit übertragenen Signale mit einer Auswerteeinrichtung (79z) für den Spannungsabfall am Widerstand (79) verbunden ist.

2. Verfahren nach Anspruch 1, dadurch gekennzeichnet, daß die Übertragung von Informationen zur Schreib-Lese-Speichereinheit (73) zeitlich getrennt ist von der Übertragung von Informationen aus der Schreib-Lese-Speichereinheit (73).

3. Verfahren nach Anspruch 1 oder 2, dadurch gekennzeichnet, daß die Schreib-Lese-Speichereinheit (73) mit einem Schreibschutz (96,97) versehen ist, der durch eine spezielle Schreibinformation aktivierbar ist.

## Claims

1. A method for contactless information transfer between a data carrier (70) and a data reader (75), the data carrier and the data reader being positionable independently of each other and brought together for information transfer, characterised in that the data carrier (70) is formed with three plate-like electrodes (11, 12, 62) on its surface and in that the data reader (75) is formed with three plate-like electrodes (16, 17, 67) which are brought together with the electrodes (11, 12, 62) of the data carrier (10) for information transfer such that they form capacitors (C1, C2) by means of which at least one common circuit for the data carrier and data reader is produced, and in that two electrodes (11, 12) of the data carrier (70) are connected to an electronic write-read memory (73), via a rectifier assembly (D1, D2, D3, D4) and a transistor (T3), and the third electrode is connected, on the one hand, directly to the write input (73c), via a demodulator (D7, R7, C7) and, on the other hand, directly to the data output (73b) of a write-read memory (73), via the transistor (T3), in that an oscillator (18) is present in the data reader and data generator (75), which oscillator is connected directly to two electrodes (16, 17) and, via a resistance (79), to the third electrode (67), and whose pulse signal controls the information transfer to and from the write-read memory (73), and in that the resistance (79), on the one hand, is capable of being modulated by a unit (79A) in order to transfer information to the write-read memory (73), and, on the other hand, is connected to an evaluation unit (79z) for the voltage drop on the resistance (79) in order to evaluate the signals transferred by the write-read memory.

2. A method according to claim 1, characterised in that the transfer of information to the write-read memory (73) is separated in time from the transfer of information from the write-read memory (73).

3. A method according to claim 1 or 2, characterised in that the write-read memory (73) is provided with write protection (96, 97) which is activated by special write information.

## Revendications

1. Procédé de transmission d'informations sans contact entre un support de données (70) et un lecteur de données (75), le support de données et le lecteur de données étant situés dans des positions indépendantes et étant rapprochés l'un de l'autre pour la transmission des informations, caractérisé en ce que le support de données (70) porte sur sa surface trois électrodes plates (11, 12, 62) et en ce que le lecteur de données (75) comporte trois électrodes plates (16, 17, 67) qui sont rapprochées des électrodes (11, 12, 62) du support de données (70) pour la transmission des informations de manière à former des condensateurs (C1, C2) à travers lesquels il s'établit au moins un circuit commun pour le support de données et le lecteur de données, deux électrodes (11, 12) du support de données (70) étant connectées à une unité de mémoire électronique à enregistrement-lecture (73) par l'intermédiaire d'un dispositif redresseur (D1, D2, D3, D4) et d'un transistor (T3), et la troisième électrode étant connectée, d'une part directement à l'entrée d'enregistrement (73c) par l'intermédiaire d'un démodulateur (D7, R7, C7) et, d'autre part, directement à la sortie de données (73b) d'une unité de mémoire à enregistrement-lecture (73) par l'intermédiaire du transistor (T3), le lecteur et codeur de données (75) comprenant un oscillateur (18) qui est connecté directement à deux électrodes (16, 17) et est connecté à la troisième électrode (67) par l'intermédiaire d'une résistance (79) et dont le signal de rythme commande la transmission d'informations en direction ou en provenance de l'unité de mémoire à enregistrement-lecture (73), la résistance (79) pouvant être, d'une part, modulée pour la transmission des informations à l'unité de mémoire à enregistrement-lecture (73) par un dispositif (79a) et, d'autre part, connectée à un dispositif d'analyse (79z) de la chute de tension sur la résistance (79), pour l'analyse des signaux transmis en provenance de l'unité de mémoire à enregistrement-lecture.

2. Procédé selon la revendication 1, caractérisé en ce que la transmission d'informations à l'unité de mémoire à enregistrement-lecture (73) est séparée dans le temps de la transmission d'informations en provenance de l'unité de mémoire à enregistrement-lecture (73).

3. Procédé selon la revendication 1 ou 2, caractérisé en ce que l'unité de mémoire (73) à enregistrement-lecture est munie d'une protection d'enregistrement (96, 97) qui peut être activée par une information d'enregistrement spéciale.
